(19) Europäisches Patentamt
European Patent Office
Office européen des brevets

(11) Numéro de publication : **0 040 127**
**B1**

# (12) FASCICULE DE BREVET EUROPÉEN

(45) Date de publication du fascicule du brevet : **04.07.84**

(51) Int. Cl.[3] : **H 03 F 1/32**, H 04 B 3/06

(21) Numéro de dépôt : **81400667.2**

(22) Date de dépôt : **28.04.81**

(54) **Dispositif de transmission de signaux comportant un circuit de précorrection de produits de non-linéarité.**

(30) Priorité : **14.05.80 FR 8010847**

(43) Date de publication de la demande : **18.11.81 Bulletin 81/46**

(45) Mention de la délivrance du brevet : **04.07.84 Bulletin 84/27**

(84) Etats contractants désignés : **DE GB IT**

(56) Documents cités :
**FR-A- 2 312 152**
**FR-A- 2 394 214**
**US-A- 3 693 109**

(73) Titulaire : **L.G.T. LABORATOIRE GENERAL DES TELECOMMUNICATIONS**
**51, boulevard de la République**
**F-78400 Chatou (FR)**

(72) Inventeur : **Cluniat, Claude**
**THOMSON-CSF SCPI 173, bld Haussmann**
**F-75360 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

EP 0 040 127 B1

Jouve, 18, rue St-Denis, 75001 Paris, France

**Description**

L'invention se rapporte à un dispositif de transmission de signaux comportant un circuit de précorrection de produits de non-linéarité.

La transmission des signaux de télévision exige des systèmes très linéaires, que ce soit au niveau des amplificateurs à faible bruit de réception, au niveau des convertisseurs en fréquence intermédiaire ou au niveau des étages de puissance de l'émetteur.

En effet, un signal de télévision, qui se compose d'une porteuse image modulée en amplitude, et d'une porteuse son modulée suivant le standard en amplitude ou en fréquence, doit être amplifié très linéairement pour que le signal démodulé soit fidèle. Les non-linéarités obtenues dans un étage produisent une altération des signaux transmis. On observe par exemple dans la voie image une modification des contrastes, des couleurs, et dans la voie son une distorsion des basses fréquences. Elles peuvent aussi produire, dans le cas où les signaux image et son sont amplifiés simultanément, des phénomènes perturbateurs extrêmement gênants dus aux transferts de modulation (ou cross-modulation) d'une porteuse sur l'autre qui se traduisent par le moirage des images, la dégradation du rapport signal/bruit etc...

Pour toutes ces raisons, les équipements d'émission et de réémission de télévision de faible et de moyenne puissance (1 watt à 1 kilowatt) possèdent des amplificateurs polarisés en classe A, ce qui conduit à un rendement compris entre 5 et 10 %. Ce rendement peut être sensiblement augmenté avec des dispositifs de correction de non-linéarité.

Différents types de précorrection sont actuellement utilisés, pour les émetteurs de télévision, en voies image et son séparées ou en voies communes, en particulier, des circuits de précorrection à seuils, en vidéo-fréquence, ou en fréquence intermédiaire, ou des dispositifs du type à contre-réaction comportant un circuit réinjectant dans le système des produits de non-linéarité obtenus par comparaison des signaux avant et après traitement par l'amplificateur de sortie.

Toutes ces solutions ont l'inconvénient d'être particulières aux systèmes de transmission auxquels elles sont appliquées et surtout tous ces dispositifs sont en général assez difficiles à ajuster. En effet, plusieurs réglages sont nécessaires et ces réglages interagissent.

Un circuit de précorrection particulier, comportant un générateur de produits de non-linéarité, a été décrit dans la demande de brevet français n° 75 16062 déposée le 23 mai 1975 et publiée sous le n° 2 312 152 au nom de la Demanderesse. Le générateur de produits de non-linéarité possède une loi de même nature que l'amplificateur de sortie. Son niveau d'excitation est choisi de façon qu'il atteigne le même point de distorsion. Le signal d'entrée $U_e$ est transmis symétriquement vers ce générateur et vers une ligne à retard qui égalise les retards respectifs des deux voies. Les signaux fournis par le générateur de produits de non-linéarité de la forme $k'_3U_e^3$, en opposition de phase avec les produits de non-linéarité générés par l'amplificateur à corriger de la forme $-k_3U_e^3$, sont ensuite combinés avec le signal émergeant de la ligne à retard, $U_e$. Ainsi la courbe amplitude-amplitude du signal, comprimée dans l'amplificateur de sortie (du fait en particulier de ce terme de non-linéarité d'ordre 3, $-k_3U_e^3$ qui se retranche du terme $k_1$ $U_e$ d'amplification linéaire), subit une expansion préalable par le circuit de précorrection qui peut compenser, après amplification, les produits de non-linéarité introduits de façon que le signal résultant ait une distorsion minimale. Ce type de précorrection présente une excellente stabilité et une efficacité qui est naturellement variable lorsque le niveau du signal d'entrée varie. En effet, lorsque le signal d'entrée diminue, la distorsion de l'étage de sortie et simultanément celle du précorrecteur diminuent avec la même rapidité. Il y a donc correction dans une large plage.

Mais la caractéristique amplitude-fréquence du générateur de produits de non-linéarité n'est pas parfaitement plane dans toute la gamme de fréquences, et du fait des dissymétries de temps de retard de groupe et de phase des deux voies, un déphaseur variable doit être introduit pour rétablir dans une gamme de fréquences donnée une symétrie correcte.

Un tel précorrecteur est assez simple à ajuster puisqu'il suffit de régler l'amplitude des produits de non-linéarité générés et la phase relative des deux voies. Mais ces deux réglages doivent être effectués par approches successives l'un par rapport à l'autre et sont à effectuer après chaque variation du niveau d'intermodulation.

Le circuit de précorrection décrit ci-dessus ne se prête donc pas, à partir d'une mesure de produits de non-linéarité, à une correction automatique simple.

L'invention a pour objet un dispositif de transmission comportant un circuit de précorrection du type décrit ci-dessus, mais perfectionné par rapport à celui-ci du fait que la ligne à retard de la voie principale du circuit de précorrection est remplacée par un circuit ayant le même temps de retard de groupe et la même caractéristique amplitude-fréquence que ceux du générateur de produits de non-linéarité de la voie annexe. Ainsi, la correction a lieu dans une très large bande. De plus, le système est tel qu'il ne subsiste qu'un réglage qui se prête bien à une correction automatique.

Enfin ce circuit peut être réalisé en technique microélectronique, ce qui permet d'obtenir un très faible encombrement et des bandes passantes de plusieurs décades.

Selon l'invention, un dispositif de transmission de signaux pourvu d'un circuit de précorrection de produits de non-linéarité introduits par un étage amplificateur de puissance dudit dispositif, le circuit de précorrection comportant une entrée de signal, un répartiteur de puissance ayant une entrée reliée à l'entrée de signal du circuit de précorrection et deux sorties, une voie principale linéaire et une voie annexe comportant un générateur de produits de non-linéarité, respectivement reliées aux sorties du répartiteur ; ainsi qu'un additionneur de sortie, relié aux sorties de la voie principale et de la voie annexe et délivrant un signal somme des signaux fournis par ces deux voies, ledit générateur comportant un répartiteur de puissance alimentant en parallèle une voie d'amplification linéaire et une voie d'amplification non linéaire, et un soustracteur effectuant la différence entre le signal de sortie de la voie linéaire et le signal de sortie de la voie non linéaire pour générer seulement des produits de non-linéarité opposés en phase avec les produits de non-linéarité à corriger, ledit circuit de précorrection est caractérisé en ce que la voie principale comporte : un répartiteur de puissance alimentant en parallèle deux voies d'amplification linéaires, semblables à la voie linéaire du générateur de produits de non-linéarité, un additionneur réunissant les signaux de sortie de ces deux voies linéaires en un signal transmis à l'additionneur de sortie, le dispositif de transmission comportant en outre des moyens de réglage d'amplitude des produits de non-linéarité reliés à la sortie du circuit de précorrection.

L'invention sera mieux comprise et d'autres caractéristiques apparaîtront à l'aide de la description qui suit en référence aux figures annexées.

La figure 1 représente un circuit de précorrection du type comportant un générateur de produits de non-linéarité selon l'art connu.

La figure 2 représente des courbes caractéristiques du circuit de la figure 1.

La figure 3 est un schéma du circuit de précorrection du dispositif de transmission suivant l'invention.

La figure 4 est le schéma synoptique du dernier étage de l'émetteur du dispositif de transmission suivant l'invention, avec précorrection automatique.

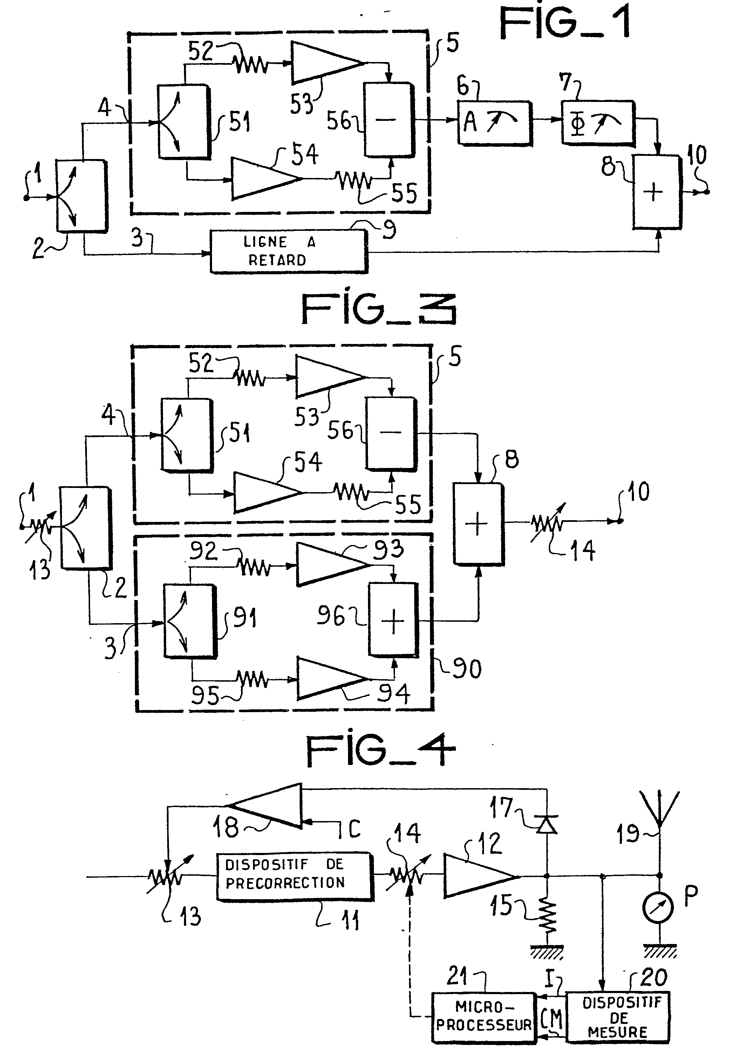

Le circuit de précorrection selon l'art connu va être décrit ci-après en référence à la figure 1.

Comme indiqué succinctement ci-dessus, le circuit de précorrection décrit dans la demande de brevet précitée comporte principalement, alimenté par l'entrée 1, un répartiteur d'entrée 2 dont les deux sorties 3 et 4 constituent les entrées de deux voies: une voie principale transmettant le signal à amplifier par l'amplificateur de sortie dont on cherche à corriger l'intermodulation et la cross-modulation, et une voie annexe comportant un générateur de produits de non-linéarité 5.

Ce générateur comprend deux amplificateurs identiques, 53 et 54, dont les niveaux d'excitation sont très différents. Pour cela, l'entrée 4 est reliée à un répartiteur 51 dont une sortie est reliée à l'entrée de l'amplificateur 53 par l'intermédiaire d'un atténuateur 52 pour former une voie d'amplification linéaire, et dont l'autre sortie 51 est reliée directement à l'amplificateur 54, un atténuateur 55 étant placé à la sortie de cet amplificateur pour former une voie d'amplification non linéaire ; les niveaux des signaux dans la voie linéaire et dans la voie non linéaire sont égaux, aux produits de non-linéarité près, avant recombinaison dans un coupleur de sortie 56. Ce coupleur de sortie est un coupleur différentiel qui extrait, des signaux présents sur ses deux entrées, les parties qui ne sont pas communes à ces deux signaux, c'est-à-dire les produits de non-linéarité opposés en phase avec les produits de non-linéarité générés par l'amplificateur à corriger. En effet, l'amplificateur 53, attaqué à faible niveau, ne produit quasiment pas de distorsion. Par contre, l'amplificateur 54, attaqué à haut niveau, produit des distorsions.

La sortie du générateur de produits de non-linéarité ainsi réalisé est reliée à l'entrée d'un circuit de commande d'amplitude, 6, dont la sortie est elle-même reliée à l'entrée d'un circuit de commande de phase, 7. Le signal émergeant est alors couplé dans un additionneur de sortie 8 avec le signal transitant par la voie principale qui comporte seulement une ligne à retard 9. La sortie 10 de l'additionneur 8 délivre alors un signal dans lequel la distorsion introduite par les produits de non-linéarité est en sens contraire de la distorsion à corriger. Mais comme indiqué ci-dessus, la dissymétrie de la voie principale, comportant la ligne à retard, et de la voie annexe, comportant le générateur de non-linéarité, fait que la distorsion n'est pas réalisée tout à fait de la même manière dans toute la bande de fréquence, le temps de retard du groupe et la caractéristique amplitude-fréquence du générateur de produits de non-linéarité étant évidemment différents dans les deux voies, comme indiqué ci-dessus.

Pour effectuer, pendant l'exploitation, une mesure des produits de non-linéarité qui permette de réaliser une précorrection automatique dans un dispositif de transmission en exploitation, un produit de non-linéarité généré en dehors de la bande utile peut être utilisé. Un tel dispositif de mesure, en exploitation, de produits de non-linéarité a été décrit dans la demande de brevet n° 79 31 488 déposée le 21 décembre 1970 au nom de la Demanderesse.

Pour que la mesure soit exacte, il faut absolument que la correction ait lieu avec la même efficacité et suivant la même loi de phase à l'intérieur de la bande utile et à l'extérieur de cette bande, là où le produit inter-porteuses utilisé pour la mesure peut être prélevé par simple filtrage (par exemple le produit à $2\ F_I - F_S$, où $F_I$ est la fréquence porteuse image et $F_S$ la fréquence porteuse son).

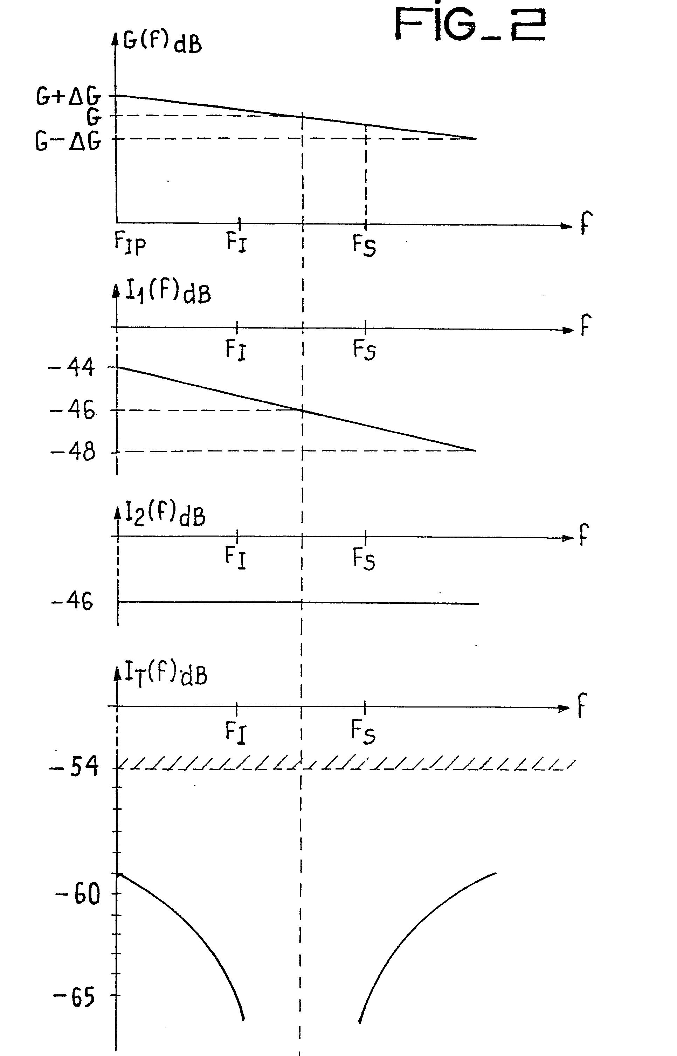

Les courbes représentées sur la ligne 2, permettent de mieux mettre en évidence le défaut à corriger pour pouvoir réaliser une mesure exacte du taux d'intermodulation. La première courbe représente la variation du gain du générateur de produits de non-linéarité, 5, dans la bande de fréquences, G(f), G étant le gain pour la fréquence centrale de la bande. Ce gain varie de part et d'autre de G de ±ΔG. L'amplitude $I_1$ des produits de non-linéarité générés par le générateur 5 n'est donc pas constante dans toute la bande de fréquences, à niveau d'entrée égal. Sa variation est représentée par la deuxième courbe de la figure 2, $I_1$(f)dB. Par contre, la ligne à retard 9 n'a aucune influence sur le niveau $I_2$(f)dB des produits de non-linéarité à corriger, représenté en fonction de la fréquence, sur la troisième courbe de la figure 2.

En conséquence, en admettant que les produits de non-linéarité se compensent exactement pour la fréquence centrale, le niveau des produits d'intermodulation résultant $I_T$, dont l'expression en fonction de $I_1$ et $I_2$ est :

$$I_{TdB} = 20 \text{ Log } (|10^{-I_2/20} - 10^{-I_1/20}|),$$

varie de part et d'autre de cette fréquence centrale. La quatrième courbe de la figure 2 représente cette variation de l'amplitude restante des produits de non-linéarité en fonction de la fréquence. Il faut noter que $I_T$ reste toujours très largement inférieur aux 54 dB requis par les normes internationales dans toute la gamme de fréquences d'un canal de télévision.

La figure 3 représente le circuit de précorrection du dispositif suivant l'invention.

Sur la figure 3, les mêmes éléments que sur la figure 1 ont été désignés par les mêmes repères.

Dans ce circuit de précorrection, l'entrée 1 est reliée à l'entrée d'un répartiteur de puissance 2 par un atténuateur variable 13. Les deux sorties, 3 et 4, de ce répartiteur alimentent respectivement une voie principale et une voie annexe. La voie annexe comporte comme précédemment un générateur de produits de non-linéarité 5 identique à celui utilisé dans le circuit décrit en référence à la figure 1. Par contre, la ligne à retard 9 du circuit de cette même figure 1 est remplacée, dans le circuit de précorrection suivant l'invention, par un circuit 90 comportant les mêmes composants que le générateur de produits de non-linéarité, 5, c'est-à-dire un répartiteur de puissance d'entrée 91 exactement semblable au répartiteur 51, deux amplificateurs 93 et 94 identiques aux amplificateurs 53 et 54, et deux atténuateurs 92 et 95 identiques aux atténuateurs 52 et 55 quant à leurs caractéristiques de phase et de temps de retard de groupe mais dont les atténuations peuvent éventuellement être différentes. Ces composants sont assemblés de façon que ce circuit 90 soit parfaitement linéaire et n'introduise donc pas de produits de non-linéarité. Pour cela, les deux voies de circuit sont organisées de la même manière que la voie dite linéaire du générateur de produits de non-linéarité. C'est-à-dire que les amplificateurs 93 et 94 sont attaqués à des niveaux d'excitation faibles, les atténuateurs 92 et 95 étant placés en amont de ces amplificateurs. Les signaux de sortie des amplificateurs 93 et 94 alimentent les deux entrées d'un additionneur 96.

Le signal émergeant de ce circuit 90 a le même temps de retard de groupe que celui transitant par la voie annexe comportant le générateur de produits de non-linéarité, et ce signal subit les mêmes atténuations en fonction de la fréquence du fait que la caractéristique amplitude-fréquence de cette voie principale est exactement la même que celle de la voie annexe. Un atténuateur variable 14 est disposé entre la sortie de l'additionneur 8 et la sortie 10 du circuit de précorrection pour ajuster la puissance de sortie de l'équipement dans lequel il s'insère.

Pour que la transmittance de ce circuit soit constante, les deux atténuateurs 13 et 14 sont couplés de telle manière que la somme des atténuations en dB soit constante.

Ce circuit est très avantageusement réalisé avec des composants micro-électroniques. En effet, il existe actuellement des amplificateurs large bande à transistors, leurs bandes pouvant couvrir la bande 5 MHz à 1 000 MHz. Les circuits additionneurs et répartiteurs tels que 8,96 et 2,51 et 91, et le circuit 56 effectuant la différence peuvent être soit des coupleurs à ferrite de déphasage 0° ou 180° (additionneur, répartiteur ou soustracteur respectivement), lorsque la bande ne dépasse pas 250 MHz, soit des coupleurs 3 décibels dont on utilise l'accès somme ou l'accès différence. Les atténuateurs peuvent être des atténuateurs électroniques (diodes PIN) réalisés en micro-électronique couche mince.

Cette nouvelle disposition conduit à une simplification notable quant aux réglages à effectuer. En effet, du fait de la symétrie parfaite des deux voies, voie annexe et voie principale, aucun élément variable supplémentaire n'est à prévoir dans ces deux voies et les circuits de commande d'amplitude et de phase (6 et 7 de la figure 1) sont maintenant inutiles. Les seuls réglages qui subsistent sont ceux des atténuateurs, 13 et 14, et ces deux réglages sont liés, une atténuation A − ΔA par l'atténuateur 13 se traduisant par une atténuation A + ΔA par l'atténuateur 14 pour que la puissance de sortie reste inchangée. Le réglage peut d'ailleurs être effectué automatiquement par une boucle de commande qui permet, à partir d'une variation d'amplitude des produits de non-linéarité générés par le circuit de précorrection, déterminant l'efficacité de la correction des produits de non-linéarité générés par l'amplificateur à corriger, d'agir automatiquement sur l'amplitude de la tension d'entrée pour que la puissance de sortie de l'amplificateur reste constante.

Le circuit de correction ainsi réalisé est à large bande et peut donc être associé à un dispositif de mesure en exploitation des produits de non-linéarité ; une telle mesure permettant de mettre en œuvre un système dans lequel la précorrection est réalisée automatiquement à partir d'une mesure de non-linéarité par le dispositif de mesure.

La figure 4 représente le dernier étage du dispositif de transmission de signaux de télévision (d'émission ou de réémission) comportant un tel circuit de précorrection, avec précorrection automatique. Le circuit représenté sur la figure 3 (à l'exception des atténuateurs 13 et 14) c'est-à-dire le circuit de précorrection, est globalement désigné par 11 sur cette figure. L'entrée de l'étage est reliée à l'entrée du circuit de précorrection par l'atténuateur variable commandable électriquement 13.

La sortie du circuit de précorrection 11 est reliée à l'entrée de l'amplificateur de sortie 12 par l'intermédiaire de l'atténuateur variable à commande électrique 14. La sortie de cet amplificateur 12 alimente un aérien d'émission 19. La puissance de sortie P peut être mesurée au moyen d'un dispositif 16, une charge 15 étant disposée à la sortie de l'amplificateur 12. En agissant, dans la bande de fréquences, sur le coefficient d'atténuation de l'atténuateur variable 14 la boucle de contre réaction constituée par un détecteur 17 et un comparateur 18 alimenté sur l'une de ses entrées par le détecteur 17 et sur l'autre par une tension de consigne C, fournit à l'atténuateur variable 13 un signal de commande proportionnel à la tension d'erreur constituée par la différence entre la tension détectée par le détecteur 17 et la tension de consigne C. Pour déterminer l'optimum dans lequel l'intermodulation et la cross-modulation sont minimales, un dispositif de mesure 20 (qui effectue un filtrage d'un produit inter-porteuses situé en dehors de la bande utile du signal transmis, par exemple le produit 2 $F_I$-$F_S$, comme décrit ci-dessus) permet, par comparaison avec des niveaux de référence prélevés dans le signal utile, de donner une mesure de l'intermodulation I et de la cross-modulation CM dans le signal transmis. Ces deux valeurs, disponibles sous forme binaire, sont transmises à un microprocesseur 21 qui calcule l'amplitude à donner aux produits de non-linéarité générés par le circuit de précorrection et qui fournit donc le signal de commande à l'atténuateur variable 14.

Comme il ressort de la description ci-dessus, le circuit de précorrection est d'une très grande souplesse d'emploi et facilite grandement la maintenance de tels équipements.

De plus, du fait que tous ses éléments peuvent être réalisés en micro-électronique, son encombrement est très faible et il peut même être introduit dans les équipements déjà réalisés. Il est également très facile à introduire dans les équipements de très faible puissance (qui sont également de très faible volume). Le taux de cross-modulation subsistant dans des dispositifs de transmission équipés de tels circuits de précorrection est inférieur à 7 % (norme requise) et le taux d'intermodulation est inférieur à – 60 dB (la norme étant – 54 dB) dans toute la bande de fréquences et même en dehors du canal de télévision.

La puissance de sortie d'une structure d'amplification est multipliée par 2,5 avec un tel circuit de précorrection, avec des performances accrues.

L'invention n'est pas limitée au mode de réalisation précédemment décrit et représenté, et il est à noter que cette structure est applicable dans les dispositifs de transmission de signaux de télévision en voies séparées ou en voies communes, en ondes métriques ou en ondes décimétriques. Ce circuit est également applicable à des dispositifs de transmission de signaux autres que des signaux de télévision, dans d'autres gammes de fréquences, lorsque leurs performances sont limitées par des non-linéarités d'ordre 3.

## Revendications

1. Dispositif de transmission de signaux pourvu d'un circuit (11, fig. 4) de précorrection de produits de non-linéarité introduits par un étage amplificateur de puissance (12, fig. 4) dudit dispositif, le circuit de précorrection comportant une entrée de signal, un répartiteur de puissance (2, fig. 3) ayant une entrée (1) reliée à l'entrée de signal du circuit de précorrection et deux sorties, une voie principale (90, fig. 3) linéaire et une voie annexe (5, fig. 3) comportant un générateur de produits de non-linéarité, respectivement reliées aux sorties du répartiteur (2) ; ainsi qu'un additionneur de sortie (8, fig. 3), relié aux sorties de la voie principale (90) et de la voie annexe (5) et délivrant un signal somme des signaux fournis par ces deux voies, ledit générateur comportant un répartiteur de puissance (51, fig. 3) alimentant en parallèle une voie d'amplification linéaire et une voie d'amplification non linéaire, et un soustracteur (56, fig. 3) effectuant la différence entre le signal de sortie de la voie linéaire et le signal de sortie de la voie non linéaire pour générer seulement des produits de non-linéarité opposés en phase avec les produits de non-linéarité à corriger, ledit circuit de précorrection étant caractérisé en ce que la voie principale (90) comporte : un répartiteur de puissance (91) alimentant en parallèle deux voies d'amplification linéaires, semblables à la voie linéaire du générateur de produits de non-linéarité, un additionneur (96) réunissant les signaux de sortie de ces deux voies linéaires en un signal transmis à l'additionneur de sortie (8), le dispositif de transmission comportant en outre des moyens (14, fig. 3) de réglage d'amplitude des produits de non-linéarité reliés à la sortie du circuit de précorrection.

2. Dispositif selon la revendication 1, caractérisé en ce que, la voie non linéaire du générateur de produits de non-linéarité comportant en série un amplificateur (54) et un atténuateur (55), et la voie linéaire comportant en série un atténuateur (52) et un amplificateur (53), les voies linéaires de la voie principale comportent en série un atténuateur (92 et 95) et un amplificateur (93 et 94) ayant les mêmes caractéristiques de phase et de temps de retard de groupe et les mêmes caractéristiques amplitude-fréquence que celles du générateur de produits de non-linéarité.

3. Dispositif selon l'une des revendications 1 et 2, caractérisé en ce que les moyens de réglage comportent deux atténuateurs (13 et 14) respectivement disposés à l'entrée et à la sortie du circuit dont les réglages fixent le niveau de précorrection en maintenant la puissance de sortie constante, la transmittance du circuit de précorrection étant ainsi maintenue constante.

4. Dispositif selon l'une quelconque des revendications précédentes, caractérisé en ce qu'une boucle de commande prélevant une fraction du signal de sortie de l'amplificateur de puissance (12), fournit, après comparaison avec un signal de référence, un signal de commande à l'atténuateur d'entrée (13) commandable électriquement, la puissance de sortie de l'amplificateur étant ainsi maintenue constante, et le réglage du niveau de précorrection étant alors défini par l'atténuateur de sortie (14).

5. Dispositif selon l'une quelconque des revendications précédentes, caractérisé en ce qu'en outre, il comporte, en exploitation, une chaîne de mesure (20, 21), des produits de non-linéarité générés par l'amplificateur de puissance (12), cette chaîne de mesure fournissant un signal de commande à l'atténuateur de sortie commandable électriquement (14) du circuit de précorrection de produits de non-linéarité de manière à effectuer une minimisation permanente et automatique de ces produits.

**Claims**

1. Signal transmission device provided with a circuit (11, Fig. 4) for precorrection of non-linearity products introduced by a power amplifier stage (12, Fig. 4) of said device, the precorrection circuit comprising a signal input, a power splitter (2, Fig. 3) having an input (1) connected to the signal input of the precorrection circuit and two outputs, a linear main channel (90, Fig. 3) and an auxiliary channel (5, Fig. 3) comprising a generator of non-linearity products respectively connected to the outputs of the splitter (2) ; as well as an output adder (8, Fig. 3) connected to the outputs of the main channel (90) and of the auxiliary channel (5) and furnishing a sun signal of the signals supplied by said two channels, said generator comprising a power splitter (51, Fig. 3) feeding in parallel a linear amplification channel and a non-linear amplification channel, and a subtracter (56, Fig. 3) forming the difference between the output signal of the linear channel and the output signal of the non-linear channel to generate only non-linearity products opposite in phase to the non-linearity products to be corrected, said precorrection circuit being characterized in that the main channel (90) comprises : a power splitter (91) feeding in parallel two linear amplification channels identical to the linear channel of the non-linearity product generator, an adder (96) combining the output signals of said two linear channels to a signal supplied to the output adder (8), the transmission device further comprising means (14, Fig. 3) connected to the output of the precorrection circuit for regulating the amplitude of the non-linearity products.

2. Device according to claim 1, characterized in that the non-linear channel of the generator of non-linearity products comprising in series an amplifier (54) and an attenuator (55), and the linear channel comprising inseries an attenuator (52) and an amplifier (53), the linear channels of the main channel comprise in series an attenuator (92 and 95) and an amplifier (93 and 94) having the same phase and group delay characteristics and the same amplitude-frequency characteristics as the generator of non-linearity products.

3. Device according to one of claims 1 and 2, characterized in that the regulating means comprise two attenuators (13 and 14) respectively disposed at the input and at the output of the circuit and the adjustments of which fix the precorrection level, keeping the output power constant, the transmittance of the precorrection circuit thus being kept constant.

4. Device according to any one of the preceding claims, characterized in that a control loop tapping off a fraction of the output signal of the power amplifier (12) furnishes, after comparison with a reference signal, a control signal to the electrically controllable input attenuator (13), the output power of the amplifier thus being kept constant, and the adjustment of the precorrection level then being defined by the output attenuator (14).

5. Device according to any one of the preceding claims, characterized in that it further comprises in utilization a measuring chain (20, 21) for measuring the non-linearity products generated by the power amplifier (12), said measuring chain supplying a control signal to the electrically controllable output attenuator (14) of the circuit for precorrection of non-linearity products so as to effect a continuous and automatic minimizing of said products.

**Ansprüche**

1. Signalübertragungsvorrichtung, die mit einer Schaltung (11, Fig. 4) zur Vorkorrektur von Nichtlinearitätsprodukten versehen ist, welche durch eine Leistungsverstärkerstufe (12, Fig. 4) der Vorrichtung verursacht werden, wobei die Vorkorrekturschaltung versehen ist mit einem Signaleingang, einem Leistungsverteiler (2, Fig. 3) mit einem an den Signaleingang der Vorkorrekturschaltung angeschlossenen Eingang (1) und zwei Ausgängen, einem linearen Hauptkanal (90, Fig. 3) und einem einen Generator zur Erzeugung von Nichtlinearitätsprodukten enthaltenden Hilfskanal (5, Fig. 3), die an den einen bzw. anderen Ausgang des Verteilers (2) angeschlossen sind, sowie einem Ausgangsaddierer (8, Fig. 3), der mit den Ausgängen des Hauptkanals (90) bzw. Hilfskanals (5) verbunden ist und ein Summensignal der von diesen beiden Kanälen gelieferten Signale abgibt, wobei der genannte Generator einen Leistungsverteiler (51, Fig. 3), welcher parallel einen linearen Verstärkungskanal und einen nichtlinearen Verstärkungskanal speist, und einen Subtrahierer (56, Fig. 3) enthält, welcher die Differenz zwischen dem Ausgangssignal des linearen Kanals und dem Ausgangssignal des nichtlinearen Kanals bildet, um nur Nichtlinearitätsprodukte zu erzeugen, welche die entgegengesetzte Phasenlage wie die zu korrigierenden Nichtlinearitätsprodukte aufweisen, wobei die Vorkorrekturschaltung dadurch gekennzeichnet ist, daß der Hauptkanal (90) umfaßt: einen Leistungsverteiler (91), der parallel zwei lineare Verstärkungskanäle speist, welche dem linearen Kanal des Nichtlinearitätsprodukt-Generators gleichen, einem Addierer (96), welcher die Ausgangssignale dieser beiden linearen Kanäle zu einem Signal vereinigt, das dem Ausgangsaddierer (8) zugeführt wird, wobei die Übertragungsvorrichtung ferner an den Ausgang der Vorkorrekturschaltung angeschlossene Mittel (14, Fig. 3) zur Einstellung der Amplitude der Nichtlinearitätsprodukte umfaßt.

2. Vorrichtung nach Anspruch 1, dadurch gekennzeichnet, daß bei einem nichtlinearen Kanal des Generators zur Erzeugung von Nichtlinearitätsprodukten, der einen Verstärker (54) in Reihe mit einem Dämpfungsglied (55) enthält, und bei einem linearen Kanal, welcher ein Dämpfungsglied (52) in Reihe mit einem Verstärker (53) enthält, die linearen Kanäle des Hauptkanals ein Dämpfungsglied (92 und 95) in Reihe mit einem Verstärker (93 und 94) enthalten, welche dieselben Phasen- und Gruppenlaufzeit-Kenndaten sowie dieselben Amplituden-Frequenz-Kenndaten wie der Generator zur Erzeugung von Nichtlinearitätsprodukten aufweisen.

3. Vorrichtung nach Anspruch 1 oder 2, dadurch gekennzeichnet, daß die Einstellmittel zwei Dämpfungsglieder (13 und 14) enthalten, die am Eingang bzw. am Ausgang der Schaltung angeordnet sind und deren Einstellung den Vorkorrekturpegel festlegt, indem sie die Ausgangsleistung konstant hält, wobei die Transmittanz der Vorkorrekturschaltung auf diese Weise konstant gehalten wird.

4. Vorrichtung nach einem der vorstehenden Ansprüche, dadurch gekennzeichnet, daß eine Regelschleife, die einen Bruchteil des Ausgangssignals des Leistungsverstärkers (12) abgreift, nach Vergleich mit einem Bezugssignal ein Steuersignal dem elektrisch steuerbaren Eingangsdämpfungsglied (13) zuführt, wobei die Ausgangsleistung des Verstärkers auf diese Weise konstant gehalten wird und die Einstellung des Vorkorrekturpegels dabei durch das Ausgangsdämpfungsglied (14) bestimmt ist.

5. Vorrichtung nach einem der vorstehenden Ansprüche, dadurch gekennzeichnet, daß sie ferner im Anwendungsfalle eine Reihenanordnung (20, 21) zur Messung der Nichtlinearitätsprodukte enthält, welche durch den Leistungsverstärker (12) erzeugt werden, wobei diese Meßreihenanordnung ein Steuersignal an das elektrisch steuerbare Ausgangsdämpfungsglied (14) der Schaltung zur Vorkorrektur von Nichtlinearitätsprodukten abgibt, so daß eine andauernde und automatische Minimierung dieser Produkte durchgeführt wird.

FIG_1
LIGNE A RETARD
FIG_3
FIG_4
DISPOSITIF DE PRECORRECTION
MICRO-PROCESSEUR
DISPOSITIF DE MESURE

FIG_2
G(f)dB
G+ΔG
G
G−ΔG
f
F_IP
F_I
F_S
I_1(f)dB
f
F_I
F_S
−44
−46
−48
I_2(f)dB
f
F_I
F_S
−46
I_T(f)dB
f
F_I
F_S
−54
−60
−65